**Europäisches Patentamt**

**European Patent Office**

**Office européen des brevets**

(11) Veröffentlichungsnummer: **0 168 771**
**A1**

## (12) EUROPÄISCHE PATENTANMELDUNG

(21) Anmeldenummer: 85108600.9

(22) Anmeldetag: 10.07.85

(51) Int. Cl.⁴: **H 01 L 21/306,** H 01 L 21/316, H 01 L 21/288, H 01 L 21/265

(30) Priorität: 17.07.84 DE 3426320

(43) Veröffentlichungstag der Anmeldung: **22.01.86** Patentblatt 86/4

(84) Benannte Vertragsstaaten: **CH DE FR GB LI SE**

(71) Anmelder: **Siemens Aktiengesellschaft, Berlin und München Wittelsbacherplatz 2, D-8000 München 2 (DE)**

(72) Erfinder: **Föll, Helmut, Dr., Albert-Schweitzer-Strasse 42, D-8000 München 83 (DE)**
Erfinder: **Gösele, Ulrich, Dr., Brunnenweg 21, D-7022 Leinfelden-Echt. 3 (DE)**
Erfinder: **Stengl, Reinhard, Dipl.-Phys, Birnauer Strasse 16, D-8000 München 40 (DE)**

(54) **Verfahren zur gezielten Erzeugung von lateralen Dotierungsgradienten in scheibenförmigen Siliziumkristallen für Halbleiterbauelemente.**

(57) Zur Anpassung an das gewünschte Profil des pn-Überganges (3, 4) wird eine Implantationsmaske (2) verwendet, deren Dicke im Randbereich (2b) entsprechend dem Verlauf des gewünschten pn-Überganges (3, 4) im Siliziumkristall (1) variiert. Die Maske wird auf dem Siliziumkristall (1) auf elektrochemischem Wege unter Ausnützung des Silizium-Elektrolyt-Kontaktes hergestellt, wobei der Stromfluß durch Licht induziert wird. Das Verfahren erlaubt eine kontinuierliche laterale Variation der implantierten Dosis über größere Ausdehnungen (einige 100 µm) und wird verwendet bei der Herstellung von Leistungshalbleiterbauelementen, insbesondere Thyristoren.

0168771

Siemens Aktiengesellschaft          Unser Zeichen
Berlin und München                  VPA  84 P 1 5 1 9 E

Verfahren zur gezielten Erzeugung von lateralen Dotierungsgradienten in scheibenförmigen Siliziumkristallen
für Halbleiterbauelemente.

Die Patentanmeldung betrifft ein Verfahren zur gezielten
Erzeugung von lateralen Dotierungsgradienten in scheibenförmigen Siliziumkristallen für Halbleiterbauelemente
unter Verwendung von die Implantation bzw. Diffusion zur
Herstellung des pn-Überganges maskierenden Schutzschichtstrukturen, bei dem in Anpassung an das gewünschte Profil
des pn-Überganges eine Implantationsmaske verwendet wird,
deren Dicke im Randbereich entsprechend dem Verlauf des
pn-Überganges im Siliziumkristall variiert, sowie eine
Vorrichtung zur Herstellung einer solchen Maske.

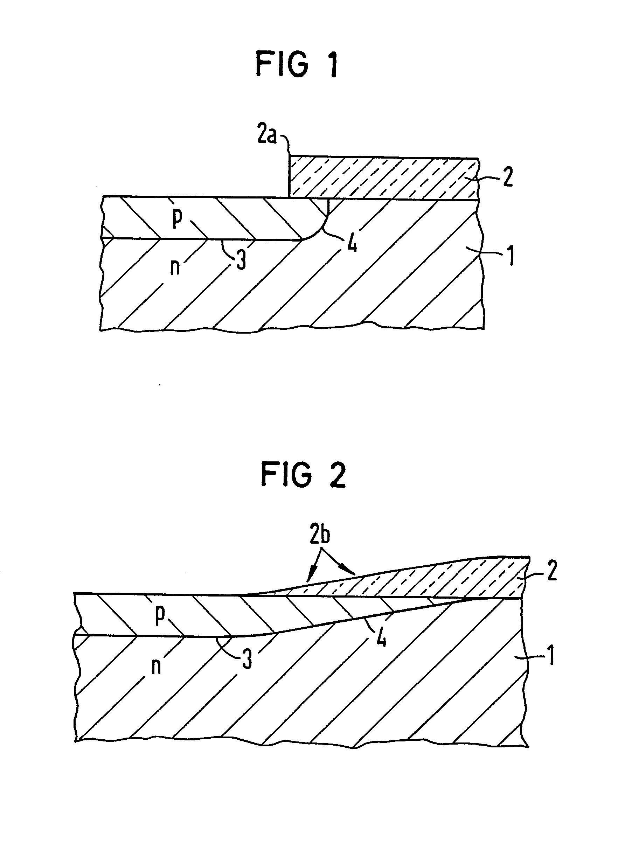

Zur Erklärung des Sachverhaltes wird zunächst auf die Figur 1 bis 3 verwiesen.

Ein pn-Übergang kann grundsätzlich dadurch erzeugt werden, daß eine ausreichende Zahl von geeigneten Dotierungsatomen durch Ionenimplantation in das zu dotierende Material eingebracht wird. Bei einem nachfolgenden Temperschritt (zum Beispiel eine Stunde bei 900°C) diffundieren
die implantierten Atome tiefer in das Silizium ein und es
bildet sich ein charakteristisches "Dotierprofil" aus,
welches in der Figur 1 dargestellt ist. Der pn-Übergang 3
entsteht dann in einer Tiefe, in der die Konzentration
des mit Hilfe der Maske 2 implantierten Dotierstoffes auf
den Wert der Grunddotierung des Siliziumkristalles 1 abgesunken ist. Der für die Tiefenlage des pn-Überganges 3 verantwortliche Verlauf des Dotierprofils hängt von der Art
Edt 1 Plr/5.7.1984

der Temperbehandlung, aber auch von der Anzahl der implantierten Dotieratome ab. Mit abnehmender Anzahl der implantierten Atome liegt der pn-Übergang 3 bei sonst gleichen Bedingungen in immer geringerer Tiefe. Mit dem Bezugszeichen 4 ist die durch Unterdiffusion entstandene laterale Struktur des pn-Überganges 3 bezeichnet. Sie weist eine starke Krümmung und dadurch eine reduzierte Durchbruchsspannung auf. Wie aus Figur 1 ersichtlich ist, stellt der Maskenrand 2a eine steile Stufe dar.

Ein für hohe Durchbruchsspannungen wünschenswertes Tiefenprofil eines pn-Überganges kann, wie in Figur 2 gezeigt, durch gezielte laterale Variation der implantierten Dosis im Prinzip erzeugt werden. Technisch ist jedoch eine laterale Variation des Ionenstromes im Implanter nicht möglich. Eine Dosisvariation der ins Silizium implantierten Atome kann jedoch durch Aufbringen einer, die zu implantierenden Ionen mehr oder weniger stark absorbierenden Schicht erreicht werden. Dies wird bei der Erzeugung von integrierten Schaltungen auch schon lange genutzt; als absorbierende Schicht dient dabei eine "Implantationsmaske" aus Fotolack, Siliziumoxid oder anderen Stoffen. Bei den bekannten Verfahren zur Maskenherstellung ist jedoch die Dicke der Maskierschicht überall konstant (wie in Figur 1 dargestellt). Die implantierte Dosis hat demnach auch nur zwei mögliche Werte.

Eine kontinuierliche laterale Variation der Dosis ist nur mit abgeschrägten Kanten 2b der absorbierenden Schicht 2 (wie in Figur 2 dargestellt) möglich. Der laterale Verlauf 4 des pn-Überganges 3 weist dabei eine kleinere Krümmung auf.

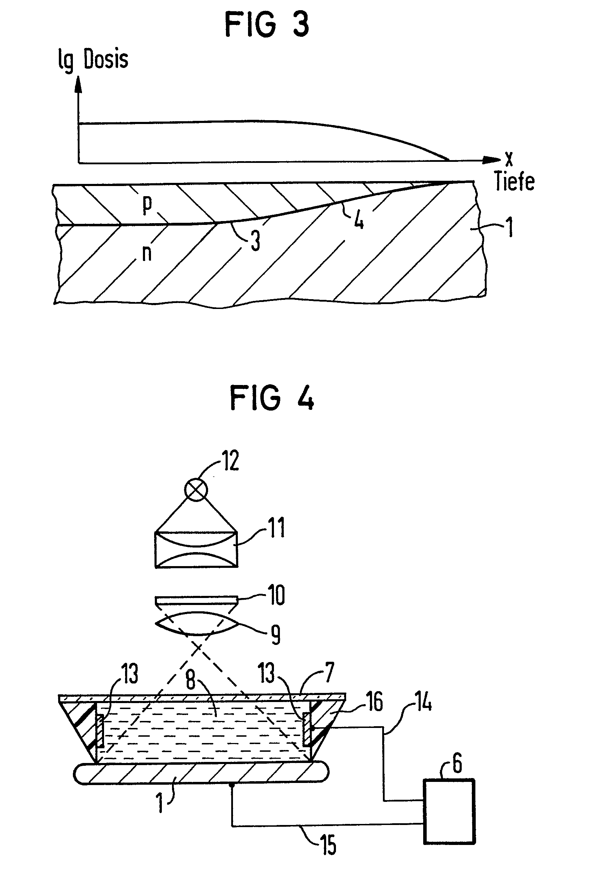

Figur 3 zeigt den qualitativen Zusammenhang zwischen zu implantierender Dosis und Tiefe x des pn-Überganges (3, 4).

Eine geringere räumliche Krümmung des pn-Überganges wird beispielsweise dadurch erreicht, daß am Rand des planaren pn-Überganges Feldringe eindiffundiert werden oder Graben-ätzungen angebracht werden. Eine weitere Möglichkeit besteht in der mechanischen Konturierung der Siliziumscheiben am pn-Übergang. Diese Verfahren sind dem Buch von A. Blicher "Thyristor Physics", Springer Verlag, 1976, auf den Seiten 198 bis 241 zu entnehmen.

Aus einem Aufsatz von P. Zandveld aus dem Solid State Electronics, 1976, Vol. 19, Seiten 659 bis 667 ist ein Verfahren der eingangs genannten Art bekannt, bei dem wie aus Figur 1 (Seite 661) zu ersehen ist, abgeschrägte Maskenkanten zur Erzielung kleiner räumlicher Krümmungen des pn-Überganges dadurch erzeugt werden, daß eine Siliziumoxidmaske mit konstanter Dicke vor ihrer Strukturierung mit Ionen implantiert und dadurch eine gestörte Oberflächenschicht erzeugt wird. Aufgrund des unterschiedlichen Ätzverhaltens in lateraler und vertikaler Richtung entsteht dann beim Ätzen der Maskenöffnung das abgeschrägte Maskenprofil. Die laterale Ausdehnung der Krümmung des pn-Überganges beträgt nur einige µm und ist für die Herstellung von Leistungshalleiterbauelementen, wo eine kontinuierliche laterale Variation der implantierten Dosis über größere Ausdehnungen (einige 100 µm) erforderlich ist, nicht anwendbar.

Aufgabe der Erfindung ist es daher, eine Möglichkeit zu schaffen, die Dicke der Implantationsmaske auf der Siliziumkristallscheibe gezielt so zu variieren, daß bei der Implantation bzw. Diffusion ein laterales Profil des pn-Überganges (wie in Figur 2 dargestellt) über größere Ausdehnungen (im Bereich von 30 bis 500 µm) entsteht. Insbesondere soll das Herstellverfahren der Maske gut reproduzierbar und in die Prozeßfolge der Herstellung von Halbleiterbauelementen voll kompatibel sein.

Diese Aufgabe wird durch ein Verfahren der eingangs genannten Art dadurch gelöst, daß die Implantationsmaske
auf dem Siliziumkristall auf elektrochemischem Wege unter
Ausnützung des Silizium-Elektrolyt-Kontaktes hergestellt
wird, wobei der Stromfluß durch Licht induziert wird.

Es liegt im Rahmen der Erfindung, daß die Lichtinduktion
über eine auf lithographischem Wege hergestellte Belichtungsmaske erfolgt, die über der im Elektrolyten befindlichen Siliziumkristallscheibe angeordnet wird und mit
unterschiedlich lichtdurchlässigen Stellen entsprechend
einem, der gewünschten Implantationsdosis vorgegebenen
Muster versehen ist.

Die Erfindung verwendet insbesondere zwei spezifische
Eigenschaften des Silizium-Elektrolyt-Kontaktes, nämlich:

1. Der Silizium-Elektrolyt-Übergang wirkt bei angelegter
   Spannung wie ein Schottky-Kontakt; das heißt, er ist
   für Stromfluß in einer Richtung gesperrt (positive
   Spannung am Siliziumkontakt für n-Silizium; bzw. negative Spannung für p-Silizium). Ein Stromfluß kann
   jedoch durch Beleuchtung induziert werden; der dabei
   fließende Strom ist in einfacher Weise vom eingestrahlten Lichtfluß abhängig (nähere Einzelheiten siehe dazu Bericht von Lehmann, Föll, Bernewitz und Grabmaier in Proceedings of the Flat-Plate Solar Array
   Project Research Forum on the High-Speed Growth and
   Characterization of Crystals for Solar Cells, 25. bis
   27. Juli 1983, Port St. Lucie, Florida, S. 527-545).

2. Der Stromfluß durch den Silizium-Elektrolyt-Kontakt
   bedingt immer eine chemische Reaktion. Im Falle eines
   in Sperrichtung gepolten Silizium-Elektrolyt-Kontaktes, bei dem Stromfluß durch Beleuchtung induziert
   wird, sind mögliche Reaktionen:

a) Bildung eines sogenannten "porösen Siliziums" in fluorhaltigen Elektrolyten für n-Silizium durch Stromdichten kleiner als ein bestimmter, hauptsächlich durch die Fluor-Konzentration gegebener Wert.

b) Bildung eines anodischen Oxids in sauerstoffhaltigen Elektrolyten für n-Silizium bei Stromdichten, die elektrolyt-spezifisch sind und

c) Abscheidung eines Kations auf p-Silizium aus geeigneten Elektrolyten.

Unter Ausnützung einer dieser drei Reaktionen läßt sich eine, wie in Figur 2 geforderte Implantationsmaske leicht erzeugen.

Gemäß einem Ausführungsbeispiel nach der Lehre der Erfindung wird die Lichtdurchlässigkeit der Belichtungsmaske nicht durch Graustufen, sondern durch ein aus der Drucktechnik bekanntes feines Muster aus vollkommen lichtundurchlässigen Punkten mit vorzugsweise quadratischer, hexagonaler oder rechteckiger Gestalt eingestellt. Dabei ist die Belichtungsmaske an Stellen, die bezogen auf die zu bearbeitende Siliziumkristallscheibe, bei der Implantation die volle Dosis erhalten sollen, lichtundurchlässig; an Stellen, die nicht implantiert werden sollen, stark lichtdurchlässig; und an Stellen, die eine bestimmte, zwischen den extremen (volle Dosis - Nulldosis) liegende Dosis erhalten sollen, teilweise lichtdurchlässig. Der Zusammenhang zwischen dem Grad der Lichtdurchlässigkeit und der geforderten Dosis errechnet sich dabei leicht über bekannte Zusammenhänge durch die Kette:

Tiefe des pn-Überganges     = f (implantierte Dosis)
Implantierte Dosis          = f (Implantationsmaskendicke)
Implantationsmaskendicke    = f (Lichtstrom bei elektro-

0168771
84 P 1519 E

chemischer Reaktion).

Das Zeichen "f (......)" steht dabei für: Funktion des Ausdrucks in der Klammer.

Die so hergestellte Belichtungsmaske wird nun auf die zu bearbeitende Siliziumscheibe projeziert. Dabei kann weißes Licht oder monochromatisches Licht verwendet werden.

Weitere Ausgestaltungen der Erfindung ergeben sich aus den Unteransprüchen.

Das Verfahren nach der Lehre der Erfindung kann durchgeführt werden mit einer Anordnung, wie sie schematisch in Figur 4 dargestellt ist. Die Siliziumkristallscheibe 1 befindet sich dabei in einer elektrolytischen Zelle, bestehend aus einem auf der Siliziumkristallscheibe 1 dicht aufsitzenden Teflonring 16, der Gegenelektrode 13 und der Zuleitungen 14 und 15 zur Spannungsquelle 6. Vermittels der einstellbaren Spannungsquelle 6 wird die Siliziumkristallscheibe 1 in Sperrichtung gepolt; der Stromfluß erfolgt nach dem zuvor Gesagten daher nur an den beleuchteten Stellen. Die Größe des lokal fließenden Stromes ist in einer für das gewählte System eindeutigen Weise vom Lichtfluß und damit von der lokalen Lichtdurchlässigkeit in der Belichtungsmaske 10, die über der Siliziumkristallscheibe 1 angeordnet ist, abhängig. Die Dicke der entstehenden Schicht (zum Beispiel ein anodisches Oxid) ist wiederum in einfacher Weise durch den Stromfluß gegeben. Insgesamt wächst also eine Schicht auf, die in ihrer lokalen Dickeverteilung die Lichtdurchlässigkeitsverteilung der Belichtungsmaske 10 eindeutig widerspiegelt. Diese Schicht kann direkt, oder nach einer in einem Prozeß erfolgten "Konditionierung" (Verdichten, Nachoxidieren) als Implantationsmaske verwendet werden. Die Projektion der Belichtungsmaske 10 auf die Siliziumkristallscheibe 1 erfolgt über ein Belichtungssystem, bestehend aus einer Lichtquelle 12 mit Kondensorsystem 11 und der Belichtungsmaske 10 mit abbildender Optik 9. Mit dem Bezugszeichen 7 ist eine lichtdurchlässige, den Elektrolyten 8 abdeckende Platte bezeichnet.

Anhand von drei Ausführungsbeispielen wird die Erfindung näher erläutert:

Ausführungsbeispiel 1:

Die Siliziumkristallscheibe 1 besteht aus n-Silizium; die für die Ionen bei der Ionenimplantation absorbierende Schicht wird entweder aus porösem Silizium oder aus $SiO_2$ gebildet, welches durch selektive Oxidation der zuvor erzeugten porösen Siliziumschicht hergestellt wird. Der Elektrolyt 8 besteht in diesem Falle aus einer wäßrigen Lösung von Fluor-Ionen, zum Beispiel aus 5 %iger Flußsäure. Der positive Pol des Netzgerätes 6 wird über die Zuleitung 15 mit der Siliziumscheibe verbunden, der negative Pol über die Zuleitung 14 mit einer chemisch inerten Elektrode 13, zum Beispiel aus Platin. Der Stromfluß an den voll beleuchteten Stellen wird durch die angelegte Spannung auf Werte im Bereich einiger $mA/cm^2$ begrenzt; der optimale Wert der Stromdichte ergibt sich aus den Details des verwendeten Systems. Unter diesen Bedingungen bildet sich eine poröse Siliziumschicht auf der Siliziumkristallscheibe 1 aus, deren Dicke durch den Lichtfluß und durch die Zeitdauer des Stromflusses gesteuert werden kann. Diese Siliziumschicht kann entweder direkt als Implantationsmaske benutzt werden, da sie nach der Implantation mit bekannten chemischen Methoden sehr leicht abgeätzt werden kann (zum Beispiel durch kurzes Eintauchen in 20 %ige Kalilauge), oder sie wird in einem zweiten Schritt zunächst oxidiert. Dabei erfolgt die Oxidation schon bei niedrigen Temperaturen (zum Beispiel 700°C), so daß die Siliziumkristallscheibe 1 selbst im vernachlässigbarem Ausmaß oxidiert wird. Das Ablösen des Oxids nach der Implantation erfolgt mit bekannten Naß-
oder Trockenätzprozessen.

Ausführungsbeispiel 2:

Die Siliziumkristallscheibe 1 besteht aus n-Silizium; die
für Ionen absorbierende Schicht wird aus anodischem Oxid
gebildet. Der Elektrolyt besteht in diesem Falle aus
einem oxidierenden Medium; dies kann zum Beispiel eine
Lösung von 4 gr. Kaliumnitrat in Äthylenglykol mit 50 ml
Wasser sein. Andere Elektrolyten sind jedoch auch möglich;
als vorteilhaft hat sich zum Beispiel 10 %ige Salpetersäure erwiesen. Der positive Pol des Netzgerätes 6 wird
wiederum über die Zuleitung 15 mit der Siliziumscheibe 1
verbunden, der negative Pol (14) mit der Gegenelektrode
13. Die optimalen Stromdichten hängen wiederum vom gewählten System ab; bei 10 %iger Salpetersäure erwiesen sich
zum Beispiel 4 mA/cm$^2$ als günstig. Die dazu benötigte
Spannung wird mit zunehmender Zeit ansteigen und liegt im
Bereich von 5 bis 100 V. Die sich bei Stromfluß bildende
Schicht auf der Siliziumkristallscheibe 1 besteht in
diesem Falle aus porösem $SiO_2$ (anodisches Oxid), dessen
Dicke wiederum durch die lokale Stromdichte und deshalb
durch den Lichtfluß bestimmt wird; außerdem natürlich
auch durch die Zeitdauer der anodischen Oxidation. Das
entstandene anodische Oxid ist direkt als Implantationsmaske einsetzbar und kann durch bekannte Methoden wieder
abgelöst werden.

Ausführungsbeispiel 3:

Die Siliziumkristallscheibe besteht aus p-Silizium; die
für Ionen absorbierende Schicht wird aus einem Metall,
zum Beispiel aus Nickel gebildet. Der Elektrolyt 8 besteht aus einer Lösung eines Nickelsalzes im Wasser, gegebenenfalls unter Zugabe von den pH-Wert des Elektrolyten 8 kontrollierenden Substanzen. Der negtive Pol des

0168771

Netzgerätes 6 ist über die Zuleitung 14 mit der Siliziumkristallscheibe 1 verbunden; der positive Pol (15) liegt an der Gegenelektrode 13. Die Abscheidung des Metalles erfolgt je nach Lichtintensität nur an den beleuchteten Stellen. Dabei muß in Rechnung gestellt werden, daß der Stromfluß mit der Zeit absinkt, da ein Teil des Lichtes in der sich bildenden Metallschicht absorbiert wird. Es ist jedoch möglich statt des Metalles eine durchsichtige, elektrisch leitfähige Verbindung abzuscheiden, die zum Beispiel aus Zinnoxid besteht. Die so gebildete Schicht kann dann direkt als Implantationsmaske verwendet werden und nach der Implantation mit bekannten Mitteln wieder abgelöst werden.

16 Patentansprüche
 4 Figuren

0168771

Patentansprüche

1. Verfahren zur gezielten Erzeugung von lateralen Dotierungsgradienten in scheibenförmigen Siliziumkristallen für Halbleiterbauelemente unter Verwendung von die Implantation bzw. Diffusion zur Herstellung des pn-Überganges maskierenden Schutzschichtstrukturen, bei dem in Anpassung an das gewünschte Profil des pn-Überganges eine Implantationsmaske verwendet wird, deren Dicke im Randbereich entsprechend dem Verlauf des pn-Überganges im Siliziumkristall variiert, d a d u r c h   g e k e n n - z e i c h n e t ,  daß die Implantationsmaske auf dem Siliziumkristall (1) auf elektrochemischem Wege unter Ausnützung des Silizium-Elektrolyt-Kontaktes (8) hergestellt wird, wobei der Stromfluß (14, 15, 6) durch Licht (9, 10, 11, 12) induziert wird.

2. Verfahren nach Anspruch 1, d a d u r c h   g e - k e n n z e i c h n e t ,  daß die Lichtinduktion über eine auf lithographischem Wege hergestellte Belichtungsmaske (10) erfolgt, die über der im Elektrolyten (8) befindlichen Siliziumkristallscheibe (1) angeordnet wird und mit unterschiedlich lichtdurchlässigen Stellen entsprechend einem, der gewünschten Implantationsdosis vorgegebenen Muster versehen ist.

3. Verfahren nach Anspruch 2, d a d u r c h   g e - k e n n z e i c h n e t ,  daß die Lichtdurchlässigkeit der Belichtungsmaske (10) durch ein aus der Drucktechnik bekanntes feines Muster aus vollkommen lichtundurchlässigen Punkten mit vorzugsweise quadratischer, hexagonaler oder rechteckiger Gestalt eingestellt wird.

4. Verfahren nach mindestens einem der Ansprüche 1 bis 3, d a d u r c h   g e k e n n z e i c h n e t ,  daß nach erfolgter Projektion der Belichtungsmaske (9, 10) auf die im Elektrolyten (8) befindliche Siliziumkristallscheibe (1) mittels monochromatischen Lichtes (11, 12) die Siliziumkristallscheibe (1) in Sperrichtung (6) gepolt wird
und unter Lichteinfluß so lange der Elektrolyse ausgesetzt wird, bis das gewünschte Schichtdickenprofil der
durch die Elektrolyse auf der Siliziumkristallscheibe (1)
aufgewachsenen Schicht erreicht ist.

5. Verfahren nach mindestens einem der Ansprüche 1 bis 4,
g e k e n n z e i c h n e t   d u r c h   die Verwendung
einer positiv gepolten Siliziumkristallscheibe (1) vom
n-Leitungstyp, einer wäßrigen Lösung von Fluor-Ionen als
Elektrolyt (8), einer chemisch inerten Elektrode als Gegenelektrode (13) und einer Stromdichte (6) im Bereich
von 5 bis 20 mA/cm$^2$.

6. Verfahren nach Anspruch 5,   d a d u r c h   g e -
k e n n z e i c h n e t ,   daß eine 5 %ige Flußsäurelösung (8) verwendet wird.

7. Verfahren nach Anspruch 5 und/oder 6,   d a d u r c h
g e k e n n z e i c h n e t ,   daß die gebildete Schicht
aus porösem Silizium bei Temperaturen im Bereich von
700°C zu SiO$_2$ aufoxidiert wird.

8. Verfahren nach mindestens einem der Ansprüche 1 bis 4,
g e k e n n z e i c h n e t   d u r c h   die Verwendung
einer positiv gepolten Siliziumkristallscheibe (1) vom
n-Leitungstyp, einer mit einem Oxidationsmittel versetzten wäßrigen Lösung als Elektrolyten (8), einer aus inertem Material bestehenden Elektrode (13) als Gegenelektrode und einer Stromdichte (6) im Bereich von 1 bis 5
mA/cm$^2$ und einer Spannung im Bereich von 10 bis 40 V.

9. Verfahren nach Anspruch 8,   d a d u r c h   g e -
k e n n z e i c h n e t ,   daß als Elektrolyt (8) eine
wäßrige Lösung von in Äthylenglykol gelöstem Kaliumnitrat verwendet wird.

10. Verfahren nach Anspruch 8, d a d u r c h   g e - k e n n z e i c h n e t , daß eine 10 %ige Salpersäurelösung verwendet wird, die Stromdichte auf 4 mA/cm$^2$ und die Spannung im Bereich von 5 bis 100 V eingestellt wird.

11. Verfahren nach mindestens einem der Ansprüche 1 bis 4, g e k e n n z e i c h n e t   d u r c h   die Verwendung einer negativ gepolten Siliziumkristallscheibe (1) vom p-Leitungstyp, einer wäßrigen, ein Metallsalz oder eine elektrisch leitfähige Verbindung enthaltenden Lösung als Elektrolyten (8) und einer im Elektrolyten resistenten Gegenelektrode (13).

12. Verfahren nach Anspruch 11, d a d u r c h   g e - k e n n z e i c h n e t , daß als Elektrolyt (8) eine wäßrige Lösung eines Nickelsalzes, gegebenenfalls unter Zugabe von den pH-Wert des Elektrolyten kontrollierenden Substanzen verwendet wird.

13. Verfahren nach mindestens einem der Ansprüche 1 bis 12, d a d u r c h   g e k e n n z e i c h n e t , daß als Gegenelektrode (13) Platin verwendet wird.

14. Verfahren nach mindestens einem der Ansprüche 1 bis 13, d a d u r c h   g e k e n n z e i c h n e t , daß die durch Elektrolyse gebildete Implantationsmaske vor ihrer eigentlichen Verwendung einer Nachbehandlung in Form einer Verdichtung und/oder Nachoxidation unterzogen wird.

15. Vorrichtung zur Durchführung des Verfahrens nach mindestens einem der Ansprüche 1 bis 14, g e k e n n - z e i c h n e t   d u r c h

a) eine elektrolytische Zelle (1, 8, 13 bis 16) mit einstellbarer Spannungs- bzw. Stromquelle (6),

b) einer das Elektrolytgefäß abdeckende lichtdurchlässigen Platte (7) und

c) einem, über der Platte (7) angeordneten lichtoptischen Projektionssystem (9 bis 12), bestehend aus Lichtquelle (12) mit Kondensorsystem (11) und Belichtungsmaske (10) mit abbildender Optik (9).

16. Verwendung des Verfahrens und der Vorrichtung nach mindestens einem der Ansprüche 1 bis 15 zur Herstellung von Implantationsmasken für die Fertigung von Leistungshalbleiterbauelementen.

# FIG 1

# FIG 2

# FIG 3

lg Dosis

x
Tiefe

p

n

3

4

1

# FIG 4

Europäisches
Patentamt

**EUROPÄISCHER RECHERCHENBERICHT**

0168771
Nummer der Anmeldung

EP 85 10 8600

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.4) |
|---|---|---|---|
| D,A | SOLID STATE ELECTRONICS, Band 19, 1976, Seiten 659-667, Pergamon Press, Oxford, GB; P. ZANDVELD: "Some properties of ion-implanted p-n junctions in silicon" <br><br> --- | | H 01 L 21/306 <br> H 01 L 21/316 <br> H 01 L 21/288 <br> H 01 L 21/265 |
| A | US-A-3 345 274 (P.F. SCHMIDT) <br><br> --- | | |
| A | US-A-4 092 445 (N. TSUZUKI u.a.) <br><br> --- | | |
| A | WO-A-8 203 801 (WESTERN ELECTRIC) <br><br> --- | | |
| A | US-A-4 217 183 (R.L. MELCHER u.a.) <br><br> ----- | | RECHERCHIERTE SACHGEBIETE (Int. Cl.4) <br><br> H 01 L 21 |

Der vorliegende Recherchenbericht wurde für alle Patentansprüche erstellt.

| Recherchenort DEN HAAG | Abschlußdatum der Recherche 10-10-1985 | Prüfer PELSERS L. |
|---|---|---|